# EUROPEAN PATENT SPECIFICATION

(11) **EP 0 763 144 B1**
(45) Date of publication and mention of the grant of the patent: **08.08.2001**
(21) Application number: 95921587.2
(22) Date of filing: 02.06.1995
(51) Int. Cl.: C23C 16/00, C23C 16/26, C23C 16/50

(54) **PRODUCTION OF CARBON-COATED BARRIER FILMS WITH INCREASED CONCENTRATION OF CARBON WITH TETRAHEDRAL COORDINATION**
HERSTELLUNG VON KOHLENSTOFFBESCHICHTETEN BARRIEREFILMEN MIT ERHÖHER KONZENTRATION VON KOHLENSTOFFATOMEN MIT TETRAEDRISCHER KOORDINATION
FABRICATION DE FILMS PROTECTEUR DE CARBONE PRESENTANT UNE CONCENTRATION SUPERIEURE DE CARBONE A COORDINATION TETRAEDRIQUE

(30) Priority: 03.06.1994 US 253991
(43) Date of publication of application: 19.03.1997
(73) Proprietor: MOBIL OIL CORPORATION, Fairfax, Virginia 22037-0001 (US)
(72) Inventor: WAGNER, John Ralph, Jr., New York, NY 14620 (US)
(74) Representative: Samuels, Lucy Alice
(86) International application number: US9507022
(87) International publication number: WO9533864

(56) References cited:
- EP-A- 0 359 567
- US-A- 4 756 964
- US-A- 4 919 974
- US-A- 5 132 105
- PATENT ABSTRACTS OF JAPAN vol. 011, no. 317 (C-452), 15 October 1987 & JP 62 103367 A (NIPPON TELEGR & TELEPH CORP), 13 May 1987,

## Description

The present invention relates to carbon-coated barrier films and, more particularly, to carbon-coated barrier films having increased concentration of tetrahedrally-coordinated carbon which impart diamond-like characteristics to the coating.

Carbon coatings are known to provide certain barrier characteristics. For example, a carbon coating can inhibit the transmission of elements such as water and oxygen. Accordingly, carbon coatings are commonly applied to substrates (e.g., polymeric films), which otherwise would not possess these barrier characteristics. Films having such carbon coatings are often referred to as barrier films.

Carbon coatings can be deposited on substrates through various techniques. One preferred technique is Plasma Enhanced Chemical Vapor Deposition (PECVD), which allows carbon to be deposited on low-temperature substrates such as polymeric films. This technique allows the deposition of carbon at lower reaction chamber temperatures as compared to the reaction chamber temperatures required in other deposition processes. As a result, the lower reaction chamber temperature allows carbon to be deposited on low-temperature substrates.

JP-A-62,103,367 discloses a process for manufacturing diamond state carbon film by CVD or thermal decomposition of a hydrocarbon gas having a structure similar to diamond or graphite. Optionally, hydrogen gas is mixed with the gaseous hydrocarbon.

Deposited carbon imparts barrier characteristics to the film. However, various commercial applications require impermeability greater than that accomplished by traditional carbon deposition alone. Accordingly, there exists a need in the art for a method of improving and/or enhancing the barrier characteristics of a carbon coating produced through PECVD techniques.

The present invention provides a process for producing a film having enhanced barrier properties. The process includes the step of depositing an amorphous carbon coating on a substrate by vapor deposition of a decomposable precursor in the presence of plasma. The decomposable precursor is mixed with a seed material containing a high concentration of tetrahedrally-coordinated carbon which facilitates the formation of, or increases the concentration of, tetrahedrally-coordinated carbon in the deposited carbon coating. Preferably this seed material is an organic compound having a high concentration of tetrahedrally-coordinated carbon.

In a preferred embodiment, the film is produced under dual frequency conditions. Particularly, the process includes the step of applying a primary radio frequency; for example, about 13.5 MHz to a first electrode positioned in a reaction chamber to generate the plasma and a secondary frequency of 10 kHz to 1 MHz to a second electrode positioned in the reaction chamber to facilitate deposition of the carbon coating on the substrate.

The present invention leads to a film having enhanced barrier properties. The film is produced by depositing an amorphous carbon coating on a substrate by vapor deposition of a decomposable precursor in the presence of plasma. The decomposable precursor is mixed with a seed material which facilitates the formation of, or increases the concentration of, tetrahedrally-coordinated carbon in the deposited carbon coating. Preferably this seed material is an organic compound having a high concentration of tetrahedrally-coordinated carbon.

The tetrahedrally-coordinated carbon in the amorphous coating provides such coating with diamond-like characteristics. The coating exhibits improved durability and hardness, while also exhibiting increased impermeability to water and oxygen. Thus, the present invention provides carbon-coated films having enhanced barrier properties.

The barrier films of the present invention are produced by deposition of an amorphous carbon coating onto the surface of a substrate. This carbon coating is produced by the decomposition of a gaseous precursor containing a seed material for formation of a coating. Preferably, the decomposition is accomplished through plasma enhanced chemical vapor deposition (PECVD).

Carbon atoms that hybridize into sp³ molecular orbitals are covalently attached to four other atoms in a tetrahedral coordination, similar to the cubic structure of a diamond. Accordingly, carbon coatings containing a high concentration of sp³ hybridized carbons exhibit diamond-like characteristics. These characteristics include durability, increased impermeability to oxygen and water and increased hardness.

In contrast, carbon atoms that hybridize into sp² molecular orbitals are covalently attached to three other atoms in a trigonal coordination. The unhybridized p atomic orbital forms a weak van der Waals bond with a fourth atom. Carbon atoms arranged in this type of coordination form a layered structure like that found in graphite. As a result, carbon coatings that contain a high concentration of sp² hybridized carbons exhibit a lesser degree of impermeability to oxygen and water. Moreover, coatings having a high concentration of sp² hybridized carbons may exhibit a decreased durability and hardness.

Amorphous carbon coatings typically contain both sp³ and sp² hybridized carbon atoms. Thus, the barrier properties of these coatings are dependent on the ratio of sp³ to sp² carbon atoms contained therein. It is believed that increasing the population of sp³ atoms in the carbon coating will increase the impermeability of the coating.

In accordance with the present invention, a seed material containing a high concentration of sp³ carbon atoms is added to the decomposable precursor. It is believed that the seed material acts as a template for the replication of sp³ tetrahedrally-coordinated carbons in the deposited amorphous carbon coating. Thus, the population of sp³ carbon atoms within the amorphous carbon coating is increased, thereby resulting in a carbon coating having the enhanced properties described above.

The seed material of the present invention is preferably a hydrocarbon having a high ratio of sp³ tetrahedrally-coordinated carbon atoms. It is believed to be desirable that the seed material compound has at least one tertiary or quaternary bonded carbon atom (that is, an sp³ carbon atom bonded to three or four, respectively, other carbon atoms) integrated into a carbocyclic or heterocyclic ring system; and, preferably, has at least one such atom integrated into a bridged ring system; for example, as in norbornane or quinuclidine. Preferably, the carbons in the seed material should retain their tetrahedral-coordination during the decomposition of the precursor gas. Diamondoid compounds, such as the compounds disclosed in U.S. Patent Nos. 5,019,660 and 5,053,434 are particularly preferred. One such preferred diamondoid compound is adamantane.

The seed material should preferably exist in a gaseous state under normal conditions to allow such material to be readily added to the gaseous precursor. Alternatively, the seed material should be easily capable of being transformed into a gaseous state. For example, materials that exist as a solid under ambient conditions are preferably capable of undergoing sublimation. Similarly, seed materials that exist in a liquid state under ambient conditions are preferably capable of undergoing evaporation.

It is contemplated that the amorphous carbon coatings of the present invention can be deposited on a variety of substrates. For example, the disclosed carbon coating can be deposited on polymeric films produced from polyolefins, polyesters and nylons. The polyolefins, specifically polypropylene and polyethylene, are particularly preferred substrates.

The decomposable precursor utilized in the present invention is preferably a hydrocarbon gas. This may include, but is not limited to, hydrocarbon gases having from about 1 to 20 carbon atoms. Acetylene is one particularly preferred decomposable precursor gas.

The seed material is preferably mixed with the precursor gas outside of the reaction chamber. Particularly, the precursor gas may include from 0.001% to 10% of seed material.

Upon the introduction of the decomposable precursor to the plasma, the precursor gas decomposes and is thereafter deposited on the substrate as an amorphous carbon layer. This carbon coating may range in thickness from 10 to 5000 Angstroms. The thickness of the amorphous carbon coating will be primarily dependent on the amount of time allowed for deposition.

The plasma in the present invention is generated by the application of a primary radio frequency to a first electrode. This radio frequency excites the gas mixture flowing through the chamber, thereby forming a plasma. This gas mixture is preferably a mixture of the precursor gas mentioned above, e.g., acetylene, and an inert gas such as argon. The precursor gas may also include an additional gas such as hydrogen.

Apparatuses adapted for PECVD are commercially available. Such apparatuses generally include a chamber sized for receipt of a substrate. The apparatus additionally includes a vacuum pump for evacuating the chamber, means for introducing a gas mixture to the chamber under controlled conditions, and means for generating a plasma within the chamber.

In one particularly preferred embodiment, the plasma generation means includes distally-spaced first and second electrodes, which together can be employed to introduce independent dual energy sources into the reaction chamber. A primary radio frequency of about 13.56 MHz is applied to the first electrode and a secondary frequency of between 10 KHz to 1 MHz is applied to the second electrode. Preferably, the chamber serves as the ground for both frequencies.

The primary frequency generates the plasma (by exciting the gas mixture), while the secondary frequency is believed to facilitate the deposition of the carbon on the substrate by exciting the carbon molecules being deposited. This rationale is supported by the fact that a visible change in the plasma is observed upon application of this second radio frequency.

Other means of generating the plasma are also contemplated. For example, a primary frequency of about 2.45 GHz could be applied across the electrodes. In addition, lasers or magnetic fields could be employed to excite the gas mixture.

The chamber preferably includes a substrate holder plate for supporting the substrate to be coated. This substrate holder plate is preferably integral with the second electrode. In a preferred embodiment of the present invention, the back surface (i.e., the surface facing away from the primary electrode) of the substrate holder is insulated. By insulating the back surface of the second electrode, the energy applied to the second electrode is focused in the region between the first and second electrodes. Moreover, the energy applied to the second electrode is delivered directly through the film, which is supported by the substrate holder.

In addition, the substrate holder plate may include either a flat or an arcuate support surface. It is contemplated that the use of an arcuate support surface would facilitate commercial production of the barrier films disclosed herein.

The following examples illustrate the enhanced barrier characteristics of films produced in accordance with the present invention.

### Example I

Control Sample 1 was produced. An uncoated oriented polypropylene film approximately 25.4 µm (1 mil) thick was measured for oxygen transmission (TO₂). The oxygen transmission was measured on a two station oxygen transmission measuring unit Model No.: Ox-tran 100 twin, sold under the name Mocon® which is registered to Modern Controls, Inc., of Minneapolis, Minnesota. The control sample exhibited an oxygen transmission rate of 106 cc/645cm²-1.013x10⁵ Pa-24hr (cc/100in² -atm-24hr) at 30°C and 0% relative humidity.

### Example II

Control Samples 2 and 3 were produced. Samples of orientated polypropylene (OPP) approximately 25.4 µm (1 mil) thick were cut into 28 cm (11") long by 39 cm (15.5") wide sheets and mounted on a 25.4 cm (10") by 39 cm (15.5") substrate holder plate attached to the second electrode. The substrate holder plate included an arcuate surface having a 101 cm (40") radius of curvature. The polymeric samples overhung the substrate holder plate along the length of such sample to allow the sample to be secured to the holder.

The chamber was pumped down to about 1.33x10² mPa (1 mTorr). An acetylene/argon gas mixture was then introduced into the chamber at a flow rate of 100 cm³/min, 70% of the mixture being acetylene. The pressure within the chamber was increased to a reaction pressure of about 13.3 Pa (100 mTorr) by use of a gate valve located at the inlet of the vacuum pump. A primary frequency of 13.5 MHz at a power level of 100 watts was applied to the first electrode and a secondary frequency of 95 kHz at a power level of between 25 and 100 watts was applied to the second electrode.

The samples were coated for approximately 300 seconds. Thereafter, the gas mixture was shut off and the chamber was pumped down to about 1.33x10² mPa (1 mTorr). The chamber vacuum was broken by bleeding in nitrogen gas and the samples were removed. Control Samples 2 and 3 were then tested for oxygen transmission.

### Example III

Samples 4 and 5 were produced by adding from about .1 to 1% adamantane to the acetylene/argon mixture and, thereafter, repeating the procedure described in Example II above.

### Example IV

Control samples 6 and 7 were produced using the procedure of Example II, after the back surface of the substrate holder was insulated. Specifically, the back surface of the substrate holder was insulated by adhering polypropylene thereto.

### Example V

Samples 8 and 9 were produced by adding about .1 to 1% adamantane to the precursor gas mixture and, thereafter, repeating the procedure of Example IV above.

The results from Examples I - V are summarized in the following table:

| Sample | Secondary Power (Watts) | Adamantane Flow | TO₂ |
|---|---|---|---|
| Control 1 | -- | -- | 106 |
| Control 2 | 25 | No | 57 |
| Control 3 | 100 | No | 2.4 |
| Sample 4 | 25 | Yes | 29 |
| Sample 5 | 100 | Yes | 1.5 |
| | | | |
| Control 6 | 25 | No | 7.5 |
| Control 7 | 100 | No | 1.2 |
| Sample 8 | 25 | Yes | 6.8 |
| Sample 9 | 100 | Yes | 0.8 |
| TO₂ : cc/645 cm²-1.013x10⁵ Pa-24hr (cc/100in²-atm-24hr) at 30°C and 0% relative humidity | | | |

It is apparent from the test data set forth in the previous table that the barrier characteristics of a carbon-coated film can be significantly enhanced by the addition of a seed material to the precursor gas. Particularly, the oxygen transmission rate (TO₂) of the tested films decreased from 57 cc (w/o seed material) to 29 cc (w/ seed material) when the secondary frequency was applied at a power level of 25 watts. Similarly, the oxygen transmission rate decreased from 2.4 cc (w/o seed material) to 1.5 cc (w/ seed material) when the secondary frequency was applied at a power level of 100 watts.

Further, it is apparent from the test data set forth in the previous table that the impermeability of the deposited coatings were further increased when the back surface of the second electrode was insulated. Particularly, the oxygen transmission rate decreased from 7.5 cc (w/o seed material) to 6.8 cc (w/ seed material) at a power level of 25 watts. Similarly, the oxygen transmission rate decreased from 1.2 cc (w/o seed material) to 0.8 cc (w/ seed material) at a power level of 100 watts.

## Claims

1. A process for producing a film having enhanced barrier properties, which process comprises depositing a carbon coating on a substrate by vapor deposition of a decomposable precursor in the presence of plasma, and wherein the decomposable precursor is mixed with a seed material containing a high concentration of tetrahedrally-coordinated carbon which facilitates the formation of, or increases the concentration of, tetrahedrally-coordinated carbon in the deposited carbon coating.

2. A process according to Claim 1, wherein the seed material comprises an organic compound having a high concentration of tetrahedrally-coordinated carbon.

3. A process according to Claim 2, wherein the organic compound is a diamondoid compound.

4. A process according to Claim 3, wherein the diamondoid compound is adamantane.

5. A process according to any preceding claim, wherein the decomposable precursor is mixed with from 0.001% to 10% of the seed material.

6. A process according to any preceding claim, wherein the decomposable precursor is an organic compound having from 1 to 20 carbon atoms.

7. A process according to Claim 6, wherein the organic compound is acetylene.

8. A process according to any preceding claim, wherein the substrate is formed of a material selected from the group consisting of polyolefins, polyesters and nylons.

9. A process according to any preceding claim, wherein the depositing step is accomplished under dual frequency conditions.

10. A process according to any preceding claim, wherein the depositing step includes applying a primary radio frequency to a first electrode positioned in a reaction chamber to generate the plasma and a secondary frequency of 10 kHz to 1 MHz to a second electrode positioned in the reaction chamber to facilitate deposition of the carbon coating on the substrate.

11. A process according to Claim 10, wherein the second electrode includes a substrate holder plate; and further comprises the step of positioning the substrate on the substrate holder for receipt of the carbon coating.

## Patentansprüche

1. Verfahren zur Herstellung eines Films mit besseren Sperreigenschaften, wobei das Verfahren das Abscheiden einer Kohlenstoffbeschichtung auf einem Substrat durch Bedampfen einer zersetzungsfähigen Vorstufe in Gegenwart von Plasma umfasst, und wobei die zersetzungsfähige Vorstufe mit einem Impfmaterial gemischt wird, das eine hohe Konzentration von tetraedrisch koordiniertem Kohlenstoff enthält, das die Entstehung von tetraedrisch koordiniertem Kohlenstoff in der aufgebrachten Kohlenstoffbeschichtung erleichtert oder dessen Konzentration darin erhöht.

2. Verfahren nach Anspruch 1, wobei das Impfmaterial eine organische Verbindung mit einer hohen Konzentration von tetraedrisch koordiniertem Kohlenstoff umfasst.

3. Verfahren nach Anspruch 2, wobei die organische Verbindung eine diamantoide Verbindung ist.

4. Verfahren nach Anspruch 3, wobei die diamantoide Verbindung Adamantan ist.

5. Verfahren nach einem der vorstehenden Ansprüche, wobei die zersetzungsfähige Vorstufe mit 0,001 bis 10 % des Impfmaterials gemischt wird.

6. Verfahren nach einem der vorstehenden Ansprüche, wobei die zersetzungsfähige Vorstufe eine organische Verbindung mit 1 bis 20 Kohlenstoffatomen ist.

7. Verfahren nach Anspruch 6, wobei die organische Verbindung Acetylen ist.

8. Verfahren nach einem der vorstehenden Ansprüche, wobei das Substrat aus einem Material hergestellt wird, das aus der Gruppe ausgewählt ist, die aus Polyolefinen, Polyestern und Nylon besteht.

9. Verfahren nach einem der vorstehenden Ansprüche, wobei der Abscheidungsschritt unter Zweifrequenzbedingungen erfolgt.

10. Verfahren nach einem der vorstehenden Ansprüche, wobei der Abscheidungsschritt das Anlegen einer ersten Hochfrequenz an eine erste Elektrode, die in einer Reaktionskammer angeordnet ist, wodurch das Plasma erzeugt wird, und einer zweiten Frequenz mit 10 kHz bis 1 MHz an eine zweite Elektrode umfasst, die in der Reaktionskammer angeordnet ist, wodurch das Abscheiden der Kohlenstoffbeschichtung auf dem Substrat erleichtert wird.

11. Verfahren nach Anspruch 10, wobei die zweite Elektrode eine Substrathalterungsplatte einschließt, und das außerdem den Schritt des Anordnens des Substrats auf der Substrathalterung zur Aufnahme der Kohlenstoffbeschichtung umfasst.

## Revendications

1. Un procédé de fabrication d'un film présentant des propriétés protectrices améliorées, ledit procédé comprenant le dépôt d'un revêtement de carbone sur un substrat par dépôt de vapeur d'un précurseur décomposable en présence de plasma et dans lequel le précurseur décomposable est mélangé avec un germe contenant une forte concentration de carbone à coordination tétraédrique qui facilite la formation, ou augmente la concentration, de carbone à coordination tétraédrique dans le revêtement de carbone déposé.

2. Un procédé selon la revendication 1, dans lequel le germe comprend un composé organique ayant une forte concentration en carbone à coordination tétraédrique.

3. Un procédé selon la revendication 2, dans lequel le composé organique est un composé adamantin.

4. Un procédé selon la revendication 3, dans lequel le composé adamantin est l'adamantane.

5. Un procédé selon l'une quelconque des revendications précédentes, dans lequel le précurseur décomposable est mélangé avec de 0,001 % à 10 % de germe.

6. Un procédé selon l'une quelconque des revendications précédentes, dans lequel le précurseur décomposable est un composé organique comportant de 1 à 20 atomes de carbone.

7. Un procédé selon la revendication 6, dans lequel le composé organique est l'acétylène.

8. Un procédé selon l'une quelconque des revendications précédentes, dans lequel le substrat est formé d'un matériau choisi parmi le groupe consistant en polyoléfines, polyesters et nylon.

9. Un procédé selon l'une quelconque des revendications précédentes, dans lequel l'opération de dépôt est effectuée dans des conditions de fréquence double.

10. Un procédé selon l'une quelconque des revendications précédentes, dans lequel l'opération de dépôt comprend l'application d'une radiofréquence primaire à une première électrode positionnée dans la chambre de réaction pour générer le plasma et une fréquence secondaire de 10 kHz à 1 MHz à une seconde électrode positionnée dans la chambre de réaction pour faciliter le dépôt du revêtement de carbone sur le substrat.

11. Un procédé selon la revendication 10, dans lequel la seconde électrode comporte une plaque support de substrat et comprend en outre l'opération de positionnement du substrat sur le porte-substrat pour recevoir le revêtement de carbone.
